# EUROPÄISCHE PATENTSCHRIFT

(11) **EP 3 312 993 B1**
(45) Veröffentlichungstag und Bekanntmachung des Hinweises auf die Patenterteilung: **27.01.2021**
(21) Anmeldenummer: 17196873.8
(22) Anmeldetag: 17.10.2017
(51) Int. Cl.: H03K 17/725, H02M 5/257, H02P 1/16

(54) **SCHALTUNGSANORDNUNG ZUR ANSTEUERUNG EINER ZÜNDBAREN HALBLEITERSCHALTUNG**
SWITCHING ASSEMBLY FOR ACTUATING AN IGNITABLE SEMICONDUCTOR CIRCUIT
DISPOSITIF DE COMMUTATION PERMETTANT LA COMMANDE D'UN CIRCUIT À SEMICONDUCTEUR POUVANT ÊTRE AMORCÉ

(30) Priorität: 20.10.2016 DE 102016120015
(43) Veröffentlichungstag der Anmeldung: 25.04.2018
(73) Patentinhaber: Metabowerke GmbH, 72622 Nürtingen (DE)
(72) Erfinder: Wiesner, Bernd, 73277 Owen (DE)
(74) Vertreter: Markfort, Iris-Anne Lucie

(56) Entgegenhaltungen:
- WO-A1-2010/066270
- WO-A1-2016/134669
- JP-A- S58 197 919
- JP-A- 2001 028 534
- US-A- 4 119 835

## Beschreibung

Die Erfindung betrifft eine Schaltungsanordnung zur Ansteuerung einer zündbaren Halbleiterschaltung mit einem Steuereingang, wodurch die Leistungsaufnahme eines elektrischen Verbrauchers, insbesondere eines Elektromotors in einer Elektrowerkzeugmaschine, gesteuert wird.

Eine entsprechend antreibbare Elektrowerkzeugmaschine weist wenigstens einen Netzanschluss, wenigstens einen Verbraucher, beispielsweise einen schaltbaren Elektromotor zum Antrieb der Elektrowerkzeugmaschine, der in einem Verbraucherspannungspfad angeordnet ist, sowie einen in dem Verbraucher-spannungspfad angeordneten manuell betätigbaren Netzschalter zum Ein- und Ausschalten des Verbrauchers auf. Anstelle eines schaltbaren Elektromotors kann selbstverständlich auch eine andere Art von Verbraucher oder Last, beispielsweise eine Heizspirale oder dergleichen, betrieben werden, die über wenigstens einen Netzanschluss bzw. Netzspannungseingang, sowie einen manuell betätigbaren Netzspannungsschalter zum Beaufschlagen der Last mit der Netzspannung geschaltet werden kann. Grundsätzlich ist eine solche Schaltungsanordnung für jedes erdenkliche an einer Netzspannung betreibbare Elektrogerät einsetzbar und damit insbesondere als Zündanordnung in Kombination mit einer Einschaltschutzvorrichtung für Elektrowerkzeugmaschinen geeignet.

Halbleiterschaltungen, insbesondere TRIAC - DIAC Schaltungen werden in der Praxis oftmals zum stufenlosen Schalten in Elektrowerkzeugmaschinen im sogenannten Gasgebeschalter oder in anderen Elektrogeräten eingesetzt. So ist beispielsweise in der DE 36 01 862 C2 eine Schaltungsanordnung beschrieben, bei der ein an ein Wechselstromnetz angeschlossener Elektromotor mittels einem TRIAC geregelt wird. Die Regelung erfolgt dabei derart, dass an den Steueranschluss des TRIAC ein DI-AC mit einem Widerstandsnetzwerk angeschlossen wird, wobei dieses Widerstandsnetzwerk von dem Benutzer in seinem Wert veränderlich einstellbar ist. Durch eine Änderung des Widerstandswertes wird dabei die Leistungsaufnahme des Elektromotors geregelt, und zwar derart, dass bei kleinerem Widerstand der Elektromotor eine größere Leistung aufnimmt als bei einem größeren Widerstand.

Einer der Vorteile derartiger Schalter ist darin zu sehen, dass diese vergleichsweise klein sind und wenig Bauraum in Anspruch nehmen.

Aus dem Lehrbuch "Elektronik II, Bauelemente, München 1984 im Richard Pflaum Verlag" sind Schaltvorrichtungen bekannt, die u. a. Phasenanschnittsteuerungen mit TRIAC und DIAC offenbaren, wobei beschrieben wird, wie bei erreichter Durchbruchsspannung des DIAC sich ein aufgeladener Kondensator über den DIAC in das Gate des TRIAC entlädt, wodurch der TRIAC gezündet wird.

Weiterhin ist in der Europäischen Patentschrift EP 0 681 308 B1 eine Schaltungsanordnung beschrieben, die neben einer TRIAC - DIAC - Schaltung und einem ersten Schalter, der den TRIAC mit dem Netzanschluss verbindet, einen zweiten Schalter vorsieht, durch den eine Widerstandsanordnung mit dem DIAC vom Netzanschluss trennbar ist. Beide Schalter werden über ein Betätigungselement betätigt, wobei beim Einschalten des Verbrauchers mittels des Betätigungselements zuerst der erste Schalter geschlossen wird und mit einer zeitlichen Verzögerung der zweite Schalter.

Gerade bei Elektrowerkzeugmaschinen besteht eine besondere Gefahr darin, dass die Elektrowerkzeugmaschine unbeabsichtigt in Gang gesetzt wird. Dies kann insbesondere dann der Fall sein, wenn der manuell betätigbare Netzspannungsschalter zum Ein- und Ausschalten in der Einschaltstellung feststellbar ist. In solchen Fällen kann es nämlich passieren, dass dieser in seiner Einschaltstellung steht, wenn der Anwender die Elektrowerkzeugmaschine an eine externe Spannungsquelle anschließt. Alternativ kann eine derartige unbeabsichtigte Inbetriebnahme der Elektrowerkzeugmaschine auch dadurch erfolgen, dass während des Betriebs der Elektrowerkzeugmaschine die Netzspannung ausgefallen ist und nach einer Weile unerwartet wieder verfügbar gemacht wird.

Die unbeabsichtigte und damit auch unbeaufsichtigte Inbetriebnahme der Elektrowerkzeugmaschine kann sowohl für den Anwender wie auch für andere Personen, die sich in deren Umfeld befinden, hochgradig gefährlich sein und zudem kostenträchtige Schäden an der Maschine wie an der Arbeitsumgebung hervorrufen. Um die in diesem Fall auftretenden Gefahren für den Anwender und seine Umgebung zu umgehen ist es erforderlich, dass die Elektrowerkzeugmaschine beim Anlegen der Netzspannung nicht automatisch in den eingeschalteten Betriebszustand versetzt wird.

Dementsprechend ist es aus dem Stand der Technik bekannt, bei derartigen Elektrowerkzeugmaschinen einen sogenannten Wiederanlaufschutz vorzusehen. Eine Lösung für einen solchen Wiederanlaufschutz ist beispielsweise in dem Gebrauchsmuster DE 20 2006 006 508 U1 beschrieben.

Bei dieser Lösung verhindert ein Sicherheitssystem das Anlegen elektrischer Leistung an den Motor, wenn der Ein-/Aus-Schalter beim Verbinden mit dem Spannungsnetz in der Schaltstellung EIN steht und ermöglicht das Anlegen elektrischer Leistung, wenn der Ein-/Aus-Schalter dabei in der Schaltstellung AUS steht. Hierzu ist eine Sicherheitsschaltung vorgesehen, die mit dem Ein-/Aus-Schalter verbunden ist und dessen Schaltstellung ermittelt. Die Sicherheitsschaltung weist eine Überwachungsschaltung auf, eine Relais-Steuerschaltung und ein Schaltrelais. Das Schaltrelais liegt in einem ersten elektrischen Pfad zu dem Ein-/Aus-Schalter und die Überwachungsschaltung in einem zweiten elektrischen Pfad zwischen dem Anschluss und dem Schalter bzw. dem Motor (Last). Ist der Ein-/Aus-Schalter geschlossen, fließt beim Anschluss der anliegenden Netzspannung ein Prüfstrom geringer Stärke in den zweiten Strompfad, der zur Detektion der Schaltstellung des Ein-/Aus-Schalters verwendet wird. In Abhängigkeit von dem Zustand des Schalters schaltet die Sicherheitsschaltung die Netzleistung zu dem Schalter durch oder nicht.

Als nachteilig hat sich bei dieser Lösung ergeben, dass die Überwachungsschaltung aufgrund des geringen Prüfstroms den Schaltstand des Ein-/Aus-Schalters nicht zuverlässig erkennt und dass der fließende Prüfstrom gegebenenfalls bereits eine unerwünschte Gerätefunktion auslösen kann.

Weiterhin ist aus dem deutschen Gebrauchsmuster DE 20 2008 010 454 U1 eine weitere Lösung für eine Einschaltschutzeinrichtung bekannt, bei der eine erste Abtastschaltung mit dem Netzspannungseingang verbunden ist und eine zweite Abtastschaltung ausgangsseitig mit dem Netzspannungsschalter verbunden ist. Der Netzspannungsschalter ist als üblicher Ein-/Aus-Schalter ausgebildet und manuell betätigbar. Die Einschaltschutzvorrichtung ist in einem Netzspannungsstrompfad von dem Netzspannungseingang zu der Last (beispielsweise Motor) angeordnet, wobei die Einschaltschutzvorrichtung die Schaltstellung des Netzspannungsschalters beim Anlegen der Netzspannung an dem Netzspannungseingang erkennt und nur in der Schaltstellung AUS mittels einer Halbleiterschalteinrichtung ein Schließen des Netzspannungsstrompfades zu der elektrische Last erlaubt.

Ein elektronisches Schaltelement mit Signaleingängen für die erste und die zweite Abtastschaltung sowie mit einem Signalausgang zur Ausgaben eines Ausgangssignals dient dazu, die Informationen von den Abtastschaltungen in Form von Signalen an die nachgeschaltete Halbleiterschalteinrichtung weiterzugeben. Letztere kann beispielsweise TRIACs oder Thyristoren umfassen.

Weiterhin beschreibt die noch unveröffentlichte DE 10 2015 111 921 der Anmelderin eine Zündanordnung bestehend aus TRIAC und DIAC in Kombination mit einer Wiederanlaufschutzvorrichtung. Dabei wird im Wesentlichen ein Zündkondensator verwendet, um der DIAC-TRIAC-Kombination einen Zündimpuls bereitzustellen. Der Zündkondensator kann von einer Wiederanlaufschutzvorrichtung entweder mit dem DIAC-TRIAC-Netzwerk funktional verbunden werden oder nicht verbunden werden. Folglich dient die Wiederanlaufschutzvorrichtung dazu, das Zünden des TRIAC durch den DIAC entweder zu verhindern oder freizugeben.

Insbesondere bei kleinen Elektrowerkzeugmaschinen, die keinen Sanftanlauf bzw. keine Phasenanschnittsteuerung erfordern, soll im Falle der Freigabe durch die Wiederanlaufschutzvorrichtung die Zündung des TRIAC möglichst verzögerungsfrei erfolgen, sobald dieser zündbereit ist. Damit der TRIAC zündbereit ist bzw. nach einem Zündimpuls selbstständig leitfähig bleibt, muss ausgangsseitig ein gewisser Mindeststrom zur Verfügung stehen bzw. durch den TRIAC fließen. Demzufolge verliert der TRIAC seine ausgangsseitige Leitfähigkeit immer dann, wenn sich die anliegende Wechselspannung nahe einem Nulldurchgang befindet. Folglich muss der TRIAC periodisch neu gezündet werden. Wird nun ein DIAC zur Zündung des TRIAC verwendet, liegt die Durchbruchsspannung des DIAC üblicherweise höher als die Spannung, die der TRIAC ausgangsseitig benötigt, um wieder zündfähig zu werden. Die Zündung des TRIAC erfolgt demnach später, als dies tatsächlich möglich wäre, was den Leistungsfaktor bzw. den Wirkungsgrad der Elektrowerkzeugmaschine reduziert. Eine Kombination, bestehend aus einem DIAC und einem TRIAC, kann somit insbesondere bei Verwendung von Elektrowerkzeugmaschinen kleiner Leistungsklassen und/oder bei Verwendung mit einer Wiederanlaufschutzvorrichtung unzufriedenstellend sein.

Schließlich wird auf die WO 2016/134669 A1 verwiesen, die eine gattungsgemäße Schaltungsanordnung offenbart. Die WO 2016/134669 A1 betrifft eine Vorrichtung zur Ansteuerung eines Thyristors im Wechselstrombetrieb. Zur Sicherstellung eines hohen Leistungsfaktors wird insbesondere vorgeschlagen, den Thyristor möglichst umgehend nach dessen Zündbereitschaft zu zünden. Hierzu wird ein Zündkreislauf aus einer schaltungsintegrierten Stromquelle, der Zündeinrichtung, einem Steuereingang des Thyristors und einem überwachten Anschlusspunkt des Thyristors ausgebildet.

In Anbetracht des bekannten Stands der Technik besteht eine Aufgabe der vorliegenden Erfindung darin, eine verbesserte Zündanordnung für eine zündbare Halbleiterschaltung, insbesondere einen TRIAC, bereitzustellen, die beispielsweise auch in Kombination mit einer Wiederanlaufschutzvorrichtung Verwendung finden kann, wobei die aus dem Stand der Technik bekannten Nachteile zumindest verringert werden.

Demgemäß wird eine Adapteranordnung mit den Merkmalen des Anspruchs 1 vorgeschlagen. Bei der erfindungsgemäßen Lösung ist eine Überwachungsanordnung eingerichtet, eine elektrische Spannung an einem Anschlusspunkt der zündbaren Halbleiterschaltung und/oder an einem Anschlusspunkt des elektrischen Verbrauchers zu überwachen und einen Zündimpuls an dem Steuereingang der zündbaren Halbleiterschaltung (nachfolgend als Zündungssteuereingang bezeichnet) zu erzeugen, wozu eine von der überwachten elektrischen Spannung unabhängige Spannungsquelle bzw. Stromquelle zur Erzeugung des Zündimpulses bereitgestellt ist.

Je nach Anwendungsfall und in Abhängigkeit von dem spezifischen Schaltungsaufbau kann der Anschlusspunkt der zündbaren Halbleiterschaltung bevorzugt überwacht werden oder kann die Überwachung der Spannung an einem Anschlusspunkt des elektrischen Verbrauchers angezeigt sein. Abhängig von der jeweiligen Anwendung können die Anschlusspunkte des elektrischen Verbrauchers und der zündbaren Halbleiterschaltung auch zusammenfallen.

Während im Stand der Technik ein Zündimpuls nur in direkter Abhängigkeit von der elektrischen Spannung an einem überwachten Anschlusspunkt erfolgt, kann erfindungsgemäß der Zündimpuls nunmehr unabhängig hiervon generiert werden. In der Überwachungsanordnung kann dementsprechend ein beliebiger Schwellwert vorgesehen sein, der im Gegensatz zum Stand der Technik kleiner oder gleich der Spannung sein kann, die der TRIAC ausgangsseitig benötigt, um zündbereit zu sein. Die erfindungsgemäße Überwachungsanordnung kann demnach unter Zuhilfenahme der hiervon unabhängigen Spannungsquelle eine Zündung zu einem früheren Zeitpunkt vornehmen, als dies im Stand der Technik möglich ist.

Weiterhin ist vorgesehen, dass wenigstens ein erster gesteuerter Schalter und ein zweiter gesteuerter Schalter, die jeweils einen Steuereingang umfassen, mit der Spannungsquelle bzw. Stromquelle verbunden sind und in Abhängigkeit von einem elektrischen Signal an dem Steuereingang des jeweiligen gesteuerten Schalters die Spannungsquelle bzw. Stromquelle niederohmig oder hochohmig mit dem Zündungssteuereingang der zündbaren Halbleiterschaltung zu verbinden vermögen, um dadurch einen Zündimpuls auszulösen, wobei die Steuereingänge der gesteuerten Schalter zumindest indirekt mit dem überwachten Anschlusspunkt der zündbaren Halbleiterschaltung und/oder mit dem Anschlusspunkt des elektrischen Verbrauchers verbunden sind.

Ein solcher gesteuerter Schalter kann somit als Komponente der Überwachungsanordnung ausgebildet sein, wobei bei Überschreiten eines Schwellwertes an dessen Steuereingang der Zündimpuls ausgelöst werden kann. Mit einer indirekten Verbindung ist in diesem Zusammenhang gemeint, dass der oder die Steuereingänge der gesteuerten Schalter nicht zwingend unmittelbar mit dem oder den überwachten Anschlusspunkten verbunden sein muss bzw. müssen, sondern auch weitere elektrische Komponenten zwischengeschaltet sein können.

Die Verwendung gesteuerter Schalter im Gegensatz zu beispielsweise einem DIAC oder einem digitalen Controller, die ebenfalls der Überwachung der Anschlusspunkte und Weitergabe des Zündsignals dienen können, kann von Vorteil sein, da diese Ausgestaltung wirtschaftlich günstiger, bautechnisch kompakter und elektrisch leistungssparsamer sein kann.

Weiterhin ist der erste gesteuerte Schalter einem positiven Anteil einer Wechselspannung und der zweite gesteuerte Schalter einem negativen Anteil einer Wechselspannung zugeordnet, wobei die Zuordnung mittels einer jedem gesteuerten Schalter zugeteilten Selektionsschaltung und/oder mittels einer Konfiguration des jeweiligen gesteuerten Schalters und/oder mittels der Bauweise des jeweiligen gesteuerten Schalters erfolgt.

Hierdurch kann die erfindungsgemäße Zündanordnung weiter optimiert werden. Insbesondere kann die Überwachungsanordnung auf die jeweiligen

Anwendungen, beispielsweise Bedürfnisse einer zündbaren Halbleiterschaltung und eine verwendete Wechselspannung, angepasst werden.

Weiterhin kann die Selektionsschaltung im Wesentlichen ein Diodennetzwerk umfassen.

Ein Diodennetzwerk stellt eine kompakte Realisierung der Selektionsschaltung dar. Beispielsweise kann eine Diode in Durchlassrichtung für einen positiven Anteil der Wechselspannung verschaltet sein. Dadurch wird genannter positiver Anteil der Spannung kurzgeschlossen. An einem Anschlusspunkt vor der Diode wäre somit im Wesentlichen nur ein negativer Anteil der Wechselspannung abnehmbar. In komplementärer Weise kann eine weitere Diode dazu verwendet werden, den negativen Anteil einer Wechselspannung kurzzuschließen. Zur Begrenzung des Stroms im Kurzschlussfall kann gegebenenfalls ein Widerstandsnetzwerk oder eine sonstige Strombegrenzung erforderlich sein.

Es kann weiter vorgesehen sein, dass wenigstens ein gesteuerter Schalter als Bipolartransistor in der Bauweise NPN und/oder PNP realisiert ist, der insbesondere jeweils eine Basis als Steuereingang sowohl jeweils einen Emitter und jeweils einen Kollektor umfasst. Insbesondere können zwei gesteuerte Schalter als zwei Bipolartransistoren in der Bauweise NPN und PNP realisiert sein.

Die Verwendung eines Bipolartransistors als gesteuerter Schalter ist ein in der Praxis langjährig bewährtes Konzept. Selbstverständlich wären allerdings auch andere Realisierungen des gesteuerten Schalters, beispielsweise als MOSFET, denkbar. Selbst eine Kombination verschiedener Transistortypen ist vorstellbar. Ein Bipolartransistor kann dazu verwendet werden, durch einen geringen Stromfluss in dessen Basis, also den Steuereingang, ausgangsseitig, also zwischen Emitter und Kollektor, eine hochohmige oder niederohmige Verbindung herzustellen.

Je nach Bauweise des Bipolartransistors lässt sich der notwendige Basisstrom in Größe und Vorzeichen einstellen. In der Bauweise NPN führt ein in Relation zum ausgangsseitigen Emitter des Transistors positiver Basisstrom zum ausgangsseitigen Schalten des Transistors bzw. einer ausgangsseitig niederohmigen, also elektrisch gut leitenden Verbindung. Die Bauweise PNP erfordert hingegen einen negativen Basisstrom zum ausgangsseitigen Durchschalten des Bipolartransistors. Somit kann die Wahl der Bauweise, teilweise auch in Kombination mit einer vorhergehenden Selektionsschaltung, dazu dienen, die Bipolartransistoren einem entsprechenden Anteil der Wechselspannung, positiv oder negativ, zuzuordnen.

Ferner kann vorgesehen sein, dass die Überwachungsanordnung eine Spannungsbegrenzungseinrichtung zur Spannungsbegrenzung und/oder Spannungsstabilisierung umfasst. Mit einer Spannungsbegrenzungseinrichtung kann somit vorliegend auch eine Spannungsstabilisierungseinrichtung gemeint sein.

Eine Spannungsbegrenzungseinrichtung und/oder Spannungsstabilisierungseinrichtung kann die Anforderungen an den oder die gesteuerten Schalter in vorteilhafter Weise reduzieren. Insbesondere wäre es denkbar, die zu überwachende Netzspannung bzw. Wechselspannung auf eine Kleinsignalspannung zu begrenzen. Es können dann wirtschaftlich günstige und technisch robuste gesteuerte Schalter, beispielsweise Kleinsignaltransistoren anstelle von Leistungstransistoren, eingesetzt werden.

Es kann weiterhin vorsehen sein, dass die Überwachungsanordnung ein Widerstandsnetzwerk und/oder ein Kondensatornetzwerk umfasst, um global und/oder lokal innerhalb der Überwachungsanordnung elektrische Potenzialdifferenzen anzupassen. Mit einer globalen Anpassung ist hier gemeint, dass das entsprechende Netzwerk eine Anpassung gleichermaßen für alle Komponenten der Schaltungsanordnung vorsieht. Mit einer lokalen Anpassung ist hingegen gemeint, dass Potentialdifferenzen zwischen einzelnen verbauten Komponenten der Schaltungsanordnung angepasst werden.

Da innerhalb der Überwachungsanordnung unterschiedliche elektrische Komponenten zum Einsatz kommen, müssen diese zur Sicherstellung der Funktionalität und zur Maximierung deren Lebensdauer möglichst gut aufeinander abgestimmt sein. Es kann von Vorteil sein, anstelle der elektrischen Komponenten selbst, die Potenziale innerhalb der Schaltung über Widerstands- und/oder Kondensatornetzwerke anzupassen. Ebenso wäre es denkbar, ein globales Potenzial bzw. einen maximalen Stromfluss eingangsseitig durch beispielsweise einen der Überwachungsanordnung vorgeschalteten Widerstand zu reduzieren.

Des Weiteren kann die Spannungsquelle bzw. Stromquelle schaltbar eingerichtet sein, insbesondere in Abhängigkeit eines Ausgangssignals einer Wiederanlaufschutzvorrichtung.

Eine schaltbare bzw. steuerbare Spannungsquelle bzw. Stromquelle kann eine vorteilhafte Weiterbildung der Erfindung darstellen, da dann die Möglichkeit besteht, einen Zündimpuls kontrolliert auszulösen oder nicht auszulösen. Hierzu kann es zum Beispiel vorgesehen sein, zwischen der Spannungsquelle bzw. Stromquelle einen weiteren gesteuerten Schalter, beispielsweise in Ausführung eines weiteren Bipolartransistors oder MOSFETs, einzusetzen. Ein beliebiges digitales oder analoges Netzwerk ist dann in der Lage, über ein entsprechendes Ausgangssignal die Spannungsquelle bzw. Stromquelle zu kontrollieren und dabei die Zündung der zündbaren Halbleiterschaltung bzw. des TRIAC zu blockieren, wodurch die Leistungsaufnahme eines elektrischen Verbrauchers, beispielsweise des Motors, verringert bzw. verhindert wird.

Weiter kann vorgesehen sein, dass die zündbare Halbleiterschaltung im Wesentlichen zumindest einen Thyristor und/oder TRIAC umfasst.

In der Praxis ist die Leistungsregelung von elektrischen Verbrauchern mit Hilfe von Thyristoren und/oder TRIACs ein gängiges und bewährtes Konzept. Selbstverständlich kann der Fachmann auch beliebige weitere zündbare Halbleiterschaltungen oder sonstige Schaltungen an dieser Stelle vorsehen.

Erfindungsgemäß kann vorgesehen sein, dass die Spannungsbegrenzungseinrichtung im Wesentlichen zwei gegengerichtet in Reihe geschaltete Z-Dioden umfasst, mittels derer die überwachte elektrische Spannung auf eine Kleinsignalspannung begrenzbar ist.

Die Realisierung einer Spannungsbegrenzungseinrichtung in Form von antiseriell verschalteten Z-Dioden stellt eine einfache technische Realisierung dar. Weiterhin wird hierdurch eine Nulldurchgangserkennung möglich.

Als besonders geeignet hat sich herausgestellt, dass die elektrische Spannung an einem gemeinsamen Anschlusspunkt des TRIAC und des elektrischen Verbrauchers überwacht wird oder nur der Anschlusspunkt des TRIAC überwacht wird. Dabei kann die Spannungsbegrenzungseinrichtung die im Wesentlichen gegengerichtet in Reihe geschaltete Z-Dioden umfassen, wodurch die überwachte elektrische Spannung auf die Kleinsignalspannung begrenzbar sein kann. Weiter kann das Widerstandsnetzwerk und Kondensatornetzwerk verwendet werden, die elektrischen Potenziale innerhalb der Überwachungsanordnung zwischen enthaltenen elektrischen Komponenten anzugleichen. Zudem kann ein erster Bipolartransistor der Bauweise PNP mit seiner Basis indirekt elektrisch mit dem überwachten Anschlusspunkt verbunden sein, wobei eine vorgeschaltete Selektionsschaltung im Wesentlichen eine Diode umfasst, die eingerichtet ist, den positiven Anteil der Wechselspannung von der Basis des ersten Bipolartransistors abzuführen. Der erste Bipolartransistor ist folglich eingerichtet, um einen negativen Anteil der Wechselspannung am überwachten Anschlusspunkt zu verarbeiten. In komplementärer Weise kann ein zweiter Bipolartransistor der Bauweise NPN vorgesehen sein, der mit seiner Basis indirekt elektrisch mit dem überwachten Anschlusspunkt verbunden ist, wobei eine vorgeschaltete Selektionsschaltung ebenfalls eine Diode umfasst, die nunmehr eingerichtet ist, den negativen Anteil der Wechselspannung von der Basis des zweiten Bipolartransistors abzuführen. Der zweite Bipolartransistor sieht somit die Überwachung eines positiven Anteils der Wechselspannung vor. Weiter kann vorgesehen sein, dass der erste und der zweite Bipolartransistor mit ihrem Kollektor und Emitter mit dem Zündungssteuereingang des TRIAC einerseits und der Spannungsquelle bzw. Stromquelle andererseits verbunden sind. Die beschriebenen Merkmale können selbstverständlich auch losgelöst voneinander umgesetzt werden.

Die Überwachungsanordnung kann derart ausgelegt sein, einen Zündimpuls baldmöglichst auszulösen, sobald anhand der überwachten elektrischen Spannung erkennbar ist, dass der TRIAC zündbereit ist, wobei die Spannungsquelle bzw. Stromquelle in Abhängigkeit der Ausgangssignale der Wiederanlaufschutzvorrichtung mit einer zur Zündung des TRIAC ausreichenden Spannung bzw. ausreichendem Strom beaufschlagt ist, oder nicht beaufschlagt ist.

Die Überwachung eines gemeinsamen Anschlusspunkts des TRIAC und des elektrischen Verbrauchers kann von Vorteil sein, da es sich an dieser Stelle technisch einfach überwachen lässt, ob der TRIAC zündbereit ist oder nicht. Das Überwachen am Anschlusspunkt des TRIAC ist von Vorteil, da das an diesem Knoten anliegende Potential direkt darüber bestimmt, ob der TRIAC zündbereit ist.

Zur weiteren Anpassung der elektrischen Potenziale kann in effizienter Form das Widerstandsnetzwerk und Kondensatornetzwerk verwendet werden. Vor allem kann ein der Überwachungsanordnung vorgeschalteter Widerstand die Spannung bzw. die Stromaufnahme der gesamten Schaltung sinnvoll reduzieren. Außerdem kann zur verbesserten Anpassung der Spannungsquelle bzw. Stromquelle dem TRIAC ein weiterer Widerstand vorgeschaltet sein. Zur Potenzialanpassung der jeweiligen Bipolartransistorbasis kann weiter jeweils ein Kondensator vorgesehen sein.

Die Figuren zeigen ein bevorzugtes Ausführungsbeispiel, in dem einzelne Merkmale der vorliegenden Erfindung in Kombination miteinander dargestellt sind. Diese sind jedoch auch losgelöst voneinander zu betrachten und können dementsprechend von einem Fachmann ohne Weiteres zu weiteren sinnvollen Unterkombinationen verbunden werden.

Es zeigen schematisch:
- Figur 1: eine Darstellung einer erfindungsgemäßen Schaltungsanordnung in Verbindung mit einer zündbaren Halbleiterschaltung und einem elektrischen Verbraucher in einer ersten Ausführungsform; und
- Figur 2: eine Darstellung einer erfindungsgemäß mit Einzelkomponenten realisierten Schaltungsanordnung in Verbindung mit einer zündbaren Halbleiterschaltung und einem elektrischen Verbraucher in einer zweiten Ausführungsform.

Die beiden Figuren zeigen jeweils einen Verbraucherspannungspfad zwischen der Klemme L (Phase) und Klemme N (Nullleiter), beinhaltend einen Verbraucher M und eine zündbare Halbleiterschaltung 1.

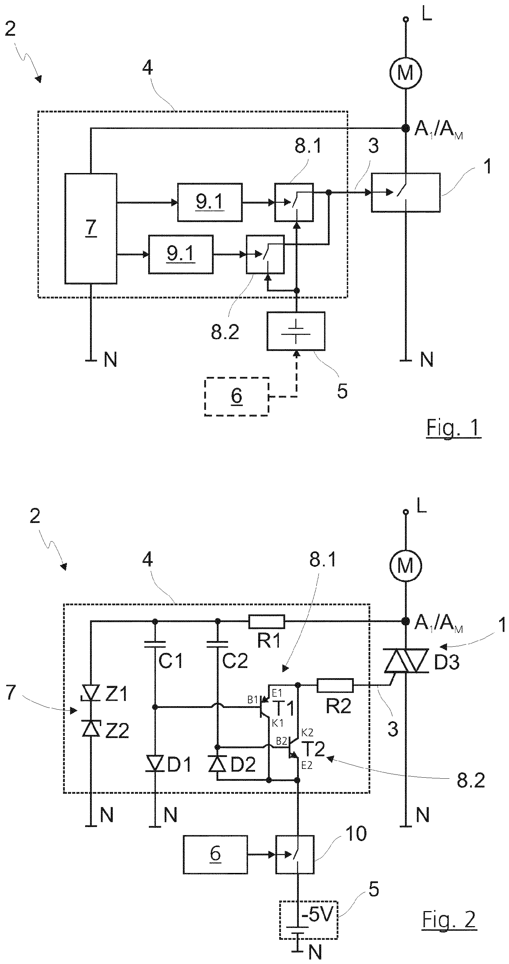

Weiter gezeigt ist in Figur 1 die erfindungsgemäße Schaltungsanordnung 2 zur Ansteuerung der zündbaren Halbleiterschaltung 1 über einen Zündungssteuereingang 3 der zündbaren Halbleiterschaltung 1. Die gezeigte Schaltungsanordnung 2 beinhaltet eine Überwachungsanordnung 4, eine von der überwachten elektrischen Spannung unabhängige Spannungsquelle bzw. Stromquelle 5 sowie eine optionale Wiederanlaufschutzvorrichtung 6.

Die Überwachungsanordnung 4 überwacht die elektrische Spannung an einem gemeinsamen Anschlusspunkt A₁/A_{M}, wobei diese über eine Spannungsbegrenzungseinrichtung 7 in die Schaltungsanordnung 2 eingebracht wird. Weiter können zwei gesteuerte Schalter 8.1, 8.2 vorgesehen sein, wobei jedem gesteuerten Schalter 8.1, 8.2 eine korrespondierende Selektionsschaltung 9.1, 9.2 vorgeschaltet ist, um jedem gesteuerten Schalter 8.1, 8.2 einen entsprechenden Anteil der überwachten Wechselspannung zuzuordnen. Abhängig von den Eingangssignalen der gesteuerten Schalter 8.1, 8.2, resultierend aus der überwachten Spannung am Anschlusspunkt A₁/A_{M}, können die gesteuerten Schalter 8.1, 8.2 die Spannung bzw. den Strom der Spannungsquelle bzw. Stromquelle 5 ausgangsseitig an den Zündungssteuereingang 3 der zündbaren Halbleiterschaltung 1 weitergeben.

Es kann dabei vorgesehen sein, dass die unabhängige Spannungsquelle bzw. Stromquelle 5 durch eine vorgeschaltete Vorrichtung, beispielsweise eine Wiederanlaufschutzvorrichtung 6, aktivierbar oder deaktivierbar ist. Somit ist es möglich, dass eine versuchte Zündung der zündbaren Halbleiterschaltung 1 durch einen der gesteuerten Schalter 8.1, 8.2 von der Wiederanlaufschutzvorrichtung 6 unterdrückt wird.

In Figur 2 ist eine besonders vorteilhafte Realisierung der abstrakten Schaltungsanordnung 2 aus Figur 1 dargestellt. Dabei ist die zündbare Halbleiterschaltung 1 als TRIAC D3 realisiert.

In der Überwachungsanordnung 4 ist die Spannungsbegrenzungseinrichtung 7 in technisch effizienter Ausgestaltung als gegengerichtet in Reihe geschaltete Z-Dioden Z1, Z2 umgesetzt. Eine Z-Diode zur Spannungsbegrenzung bzw. Spannungsstabilisierung ist aus dem Stand der Technik und aus der Praxis hinlänglich bekannt. Im vorliegenden Fall wird durch Verwendung der antiseriell geschalteten Z-Dioden im Wesentlichen ein "Abschneiden" der äußeren, betragsmäßig großen Bereiche einer beispielsweise sinusförmigen Wechselspannung erreicht.

Zur Beherrschung der globalen Potenzialdifferenz wird ein Widerstand R1 zwischen dem überwachten Anschlusspunkt A₁/A_{M} und der Überwachungsanordnung 4 vorgesehen.

Als gesteuerte Schalter 8.1, 8.2 sind, wie in der Figur 2 gezeigt, zwei Bipolartransistoren T1, T2 mit jeweils einer Basis B1, B2, einem Emitter E1, E2 und einem Kollektor K1, K2 vorgesehen. Der Transistor T1 kann in der Bauweise PNP realisiert sein, wobei er auf einen negativen Strom von Basis B1 zu Emitter E1 einen großen Stromfluss, sprich eine niederohmige Verbindung, zwischen Kollektor K1 und Emitter E1 einstellt. Um sicherzustellen, dass der Transistor T1 im Wesentlichen den negativen Anteil der Wechselspannung bzw. der Spannung am überwachten Anschlusspunkt A₁/A_{M} eingangsseitig erhält, ist zunächst ein Kondensator C1 zur Potenzialanpassung vorgesehen und weiter eine Diode D1, die den positiven Anteil der überwachten Spannung von der Basis B1 des Transistors T1 abführt. Hingegen wird ein negativer Anteil der überwachten Spannungen des Anschlusspunktes A₁/A_{M} von der Diode D1 nicht kurzgeschlossen, da sich die Diode D1 für diesen Anteil in Sperrrichtung befindet. Ein angepasster, negativer Anteil der überwachten Wechselspannung des Anschlusspunktes A₁/A_{M} liegt somit an der Basis B1 des Transistors T1 an.

Komplementär hierzu ist der Transistor T2 in der Bauform NPN realisiert, wobei dieser eine ausgangsseitig niederohmige Verbindung zwischen Kollektor K2 und Emitter E2 herstellt, wenn ein geringer positiver Strom zwischen dessen Basis B2 und dem Emitter E2 fließt. Hierzu ist dem Transistor T2 bzw. dessen Basis B2 ein Kondensator C2 zur Potenzialanpassung und eine Diode D2 vorgeschaltet. Die Diode D2 in dieser Anordnung stellt sicher, dass ein negativer Anteil der überwachten Wechselspannung am Anschlusspunkt A₁/A_{M}, der kleiner ist als die Referenzspannung am Emitter E2 des Transistors T2, d.h. kleiner als die elektrische Spannung der Spannungsquelle 5, von der Basis B2 des Transistors T2, abgeleitet wird.

Die von der überwachten elektrischen Spannung unabhängige Spannungsquelle bzw. die Stromquelle 5 kann beispielsweise eine Ausgangsspannung von -5 Volt liefern. Die Spannung der unabhängigen Spannungsquelle bzw. Stromquelle 5 wird im Falle eines geschalteten Transistors T1, T2 über einen weiteren Widerstand R2 zur Potentialanpassung an den Zündungssteuereingang 3 des TRIAC D3 weitergegeben, wodurch diese als Zündimpuls dienen kann. Zwischen der Spannungsquelle bzw. Stromquelle 5 ist ein weiterer gesteuerter Schalter 10 angeordnet, der in vorteilhafter Weise ebenfalls als Kleinsignaltransistor, beispielsweise Bipolartransistor oder MOSFET, realisiert sein kann. Der gesteuerte Schalter 10 kann die Weitergabe der Spannung bzw. des Stroms von Seiten der Spannungsquelle bzw. Stromquelle 5 in Abhängigkeit von seinem Steuereingang entweder blockieren oder weiterleiten. Durch diese Anordnung ist es einfach möglich, dass eine Intelligenz, beispielsweise in Form eines digitalen Controllers, einer analoger Ausführung oder sonstiger Bauweise, bzw. eine Wiederanlaufschutzvorrichtung 6, die Zündung der zündbaren Halbleiterschaltung 1 bzw. des TRIAC D3 steuert.

Insbesondere aus Figur 2 wird ersichtlich, dass erfindungsgemäß eine Schaltungsanordnung 2 gegeben ist, die sich durch wirtschaftlich günstige, technisch bewährte und zahlenmäßig wenige kompakte Standardkomponenten realisieren lässt. Die gezeigte Schaltungsanordnung 2 ist für sämtliche Lasten bzw. Verbraucher M, von rein ohmsch bis induktiv, geeignet. Durch eine erfindungsgemäße Überwachungsanordnung 4, umfassend beispielsweise Bipolartransistoren T1, T2 und bei einer entsprechender Auslegung der Schaltung ist im Gegensatz zum Stand der Technik eine frühestmögliche Zündung des TRIAC D3, unabhängig von der Last bzw. dem Verbraucher M, möglich. Infolgedessen kann die erfindungsgemäße Ausgestaltung einen deutlich verbesserten Leistungsfaktor zeigen, da ein etwaiger Phasenanschnitt vermieden wird, oder zumindest auf ein Mindestmaß reduziert wird.

## Patentansprüche

1. Schaltungsanordnung (2) zur Ansteuerung einer zündbaren Halbleiterschaltung (1) mit einem Zündungssteuereingang (3), um die Leistungsaufnahme eines elektrischen Verbrauchers (M), insbesondere eines Elektromotors in einer Elektrowerkzeugmaschine, zu steuern, wobei eine Überwachungsanordnung (4) eingerichtet ist, um eine elektrische Spannung an einem Anschlusspunkt (A₁) der zündbaren Halbleiterschaltung (1) und/oder an einem Anschlusspunkt (A_{M}) des elektrischen Verbrauchers (M) zu überwachen und einen Zündimpuls an dem Zündungssteuereingang (3) der zündbaren Halbleiterschaltung (1) zu erzeugen, wobei eine Spannungsquelle bzw. Stromquelle (5) zur Erzeugung des Zündimpulses bereitgestellt ist, wobei wenigstens ein erster gesteuerter Schalter (8.1,T1) und ein zweiter gesteuerter Schalter (8.2, T2), die jeweils einen Steuereingang (B1,B2) umfassen, mit der Spannungsquelle bzw. Stromquelle (5) verbunden sind und in Abhängigkeit von einem elektrischen Signal an dem Steuereingang (B1,B2) des jeweiligen gesteuerten Schalters (8.1,8.2,T1,T2) die Spannungsquelle bzw. Stromquelle (5) niederohmig oder hochohmig mit dem Zündungssteuereingang (3) der zündbaren Halbleiterschaltung (1) zu verbinden vermögen, um dadurch einen Zündimpuls auszulösen, wobei die Steuereingänge (B1,B2) der gesteuerten Schalter (8.1,8.2,T1,T2) zumindest indirekt mit dem überwachten Anschlusspunkt (A₁) der zündbaren Halbleiterschaltung (1) und/oder mit dem Anschlusspunkt (A_{M}) des elektrischen Verbrauchers (M) verbunden sind, und wobei der erste gesteuerte Schalter (8.1,T1) einem negativen Anteil einer Wechselspannung und der zweite gesteuerte Schalter (8.2,T2) einem positiven Anteil einer Wechselspannung zugeordnet ist, wobei die Zuordnung mittels einer jedem gesteuerten Schalter (8.1,8.2,T1,T2) zugeteilten Selektionsschaltung (9) und/oder mittels einer Konfiguration des jeweiligen gesteuerten Schalters (8.1,8.2,T1,T2) und/oder mittels der Bauweise des jeweiligen gesteuerten Schalters (8.1,8.2,T1,T2) erfolgt,
**dadurch gekennzeichnet, dass**
die Spannungsquelle bzw. Stromquelle (5) von der überwachten Spannung unabhängig ist.

2. Schaltungsanordnung (2) nach Anspruch1,
**dadurch gekennzeichnet, dass**
die Selektionsschaltung (9.1,9.2) im Wesentlichen ein Diodennetzwerk (D1,D2) umfasst.

3. Schaltungsanordnung (2) nach einem der Ansprüche 1 oder 2,
**dadurch gekennzeichnet, dass**
wenigstens ein gesteuerter Schalter (8.1,8.2) als Bipolartransistor (T1,T2) in der Bauweise NPN oder PNP realisiert ist, der insbesondere jeweils eine Basis (B1,B2) als Steuereingang sowie jeweils einen Emitter (E1,E2) und jeweils einen Kollektor (K1,K2) umfasst.

4. Schaltungsanordnung (2) nach einem der Ansprüche 1 bis 3,
**dadurch gekennzeichnet, dass**
die Überwachungsanordnung (4) eine Spannungsbegrenzungseinrichtung (7) zur Spannungsbegrenzung und/oder Spannungsstabilisierung umfasst.

5. Schaltungsanordnung (2) nach einem der Ansprüche 1 bis 4,
**dadurch gekennzeichnet, dass**
die Überwachungsanordnung (4) ein Widerstandsnetzwerk (R1,R2) und/oder ein Kondensatornetzwerk (C1,C2) umfasst, um global und/oder lokal innerhalb der Überwachungsanordnung (4) elektrische Potentialdifferenzen anzupassen.

6. Schaltungsanordnung (2) nach einem der Ansprüche 1 bis 5,
**dadurch gekennzeichnet, dass**
die Spannungsquelle bzw. Stromquelle (5) schaltbar eingerichtet ist, insbesondere in Abhängigkeit eines Ausgangssignals einer Wiederanlaufschutzvorrichtung (6).

7. Schaltungsanordnung (2) nach einem der Ansprüche 1 bis 6,
**dadurch gekennzeichnet, dass**
die zündbare Halbleiterschaltung (1) im Wesentlichen zumindest einen Thyristor und/oder TRIAC (D3) umfasst.

8. Schaltungsanordnung nach einem der Ansprüche 4 bis 7,
**dadurch gekennzeichnet, dass**
die Spannungsbegrenzungseinrichtung (7) im Wesentlichen zwei gegengerichtet in Reihe geschaltete Z-Dioden (Z1,Z2) umfasst, mittels derer die überwachte elektrische Spannung auf eine Kleinsignalspannung begrenzbar ist.

## Claims

1. Circuit arrangement (2) for driving an ignitable semiconductor circuit (1) with an ignition control input (3) in order to control the power consumption of an electrical consumer (M), in particular of an electric motor in an electric machine tool, a monitoring arrangement (4) being set up, in order to monitor an electrical voltage at a connection point (A₁) of the ignitable semiconductor circuit (1) and/or at a connection point (A_{M}) of the electrical load (M) and to generate an ignition pulse at the ignition control input (3) of the ignitable semiconductor circuit (1), a voltage source or at least a first controlled switch (8.1, T1) and a second controlled switch (8.2, T2), which each comprise a control input (B1, B2), are connected to the voltage source or current source (5) and, depending on an electrical signal at the control input (B1, B2) of the respective controlled switch (8.1, T1), can be switched on and off in response to an electrical signal at the control input (B1, B2) of the respective controlled switch (8.1, 8.2, T1, T2) are capable of connecting the voltage source or current source (5) to the ignition control input (3) of the ignitable semiconductor circuit (1) in a low-impedance or high-impedance manner, thereby triggering an ignition pulse, the control inputs (B1, B2) of the controlled switches (8.1, 8.2, T1, T2) are at least indirectly connected to the monitored connection point (A₁) of the ignitable semiconductor circuit (1) and/or to the connection point (A_{M}) of the electrical load (M), and wherein the first controlled switch (8.1, T1) is assigned to a negative component of an alternating voltage and the second controlled switch (8.2, T2) is assigned to a positive component of an alternating voltage, the assignment being carried out by means of a selection circuit (9) assigned to each controlled switch (8.1, 8.2, T1, T2) and/or by means of a configuration of the respective controlled switch (8.1, 8.2, T1, T2) and/or by means of the design of the respective controlled switch (8.1, 8.2, T1, T2),
**characterized in that**
the voltage source or current source (5) is independent of the monitored voltage

2. The circuit arrangement (2) according to claim 1,
**characterized in that**
the selection circuit (9.1 ,9.2) essentially comprises a diode network (D1, D2).

3. The circuit arrangement (2) according to one of claims 1 or 2,
**characterized in that**
at least one controlled switch (8.1, 8.2) is implemented as a bipolar transistor (T1, T2) of the NPN or PNP type of construction, which in particular comprises in each case one base (B1, B2) as a control input and in each case one emitter (E1, E2) and in each case one collector (K1, K2).

4. The circuit arrangement (2) according to one of claims 1 to 3,
**characterized in that**
the monitoring arrangement (4) comprises a voltage limiting device (7) for voltage limitation and/or voltage stabilization.

5. The circuit arrangement (2) according to one of claims 1 to 4,
**characterized in that**
the monitoring arrangement (4) comprises a resistor network (R1, R2) and/or a capacitor network (C1, C2) in order to adjust electrical potential differences globally and/or locally within the monitoring arrangement (4).

6. The circuit arrangement (2) according to one of claims 1 to 5,
**characterized in that**
the voltage source or current source (5) is set up to be switchable, in particular depending on an output signal of a restart protection device (6).

7. The circuit arrangement (2) according to one of claims 1 to 6,
**characterized in that**
the ignitable semiconductor circuit (1) essentially comprises at least one thyristor gate and/or TRIAC (D3).

8. The circuit arrangement according to any one of claims 4 to 7,
**characterized in that**
the voltage limiting device (7) essentially comprises two counter-directed Z-diodes (Z1, Z2) connected in series, by means of which the monitored electrical voltage can be limited to a small-signal voltage.

## Revendications

1. Arrangement de circuit (2) pour la commande d'un circuit à semi-conducteurs (1) inflammable avec une entrée de commande d'allumage (3) afin de commander la consommation de courant d'un consommateur électrique (M), en particulier d'un moteur électrique dans une machine-outil électrique, un dispositif de surveillance (4) étant mis en place, afin de surveiller une tension électrique à un point de connexion (A₁) du circuit à semi-conducteur inflammable (1) et/ou à un point de connexion (A_{M}) de la charge électrique (M) et de générer une impulsion d'allumage à l'entrée de commande d'allumage (3) du circuit à semi-conducteur inflammable (1), une source de tension ou au moins un premier interrupteur commandé (8.1, T1) et un deuxième interrupteur commandé (8.2, T2), qui comportent chacun une entrée de commande (B1, B2), sont reliés à la source de tension ou à la source de courant (5) et peuvent être activés et désactivés en fonction d'un signal électrique à l'entrée de commande (B1, B2) de l'interrupteur commandé respectif (8.1, 8.2, T1, T2) sont capables de relier la source de tension ou la source de courant (5) à l'entrée de commande d'allumage (3) du circuit à semi-conducteur allumable (1) de manière basse ou haute impédance afin de déclencher ainsi une impulsion d'allumage, les entrées de commande (B1, B2) des interrupteurs commandés (8.1, 8.2, T1, T2) sont reliés au moins indirectement au point de connexion surveillé (A₁) du circuit semi-conducteur inflammable (1) et/ou au point de connexion (A_{M}) de la charge électrique (M), et dans lequel le premier commutateur commandé (8.1, T1) est affecté à une composante négative d'une tension alternative et le deuxième interrupteur commandé (8.2, T2) est affecté à une composante positive d'une tension alternative, l'affectation étant effectuée au moyen d'un circuit de sélection (9) affecté à chaque interrupteur commandé (8.1, 8.2, T1, T2) et/ou au moyen d'une configuration de l'interrupteur commandé respectif (8.1, 8.2, T1, T2) et/ou au moyen de la conception de l'interrupteur commandé respectif (8.1, 8.2, T1, T2),
**caractérisé en ce que**
la source de tension ou de courant (5) est indépendante de la tension surveillée

2. Arrangement de circuit (2) selon la revendication 1,
**caractérisé en ce que**
le circuit de sélection (9.1, 9.2) comprend essentiellement un réseau de diodes (D1, D2).

3. Arrangement de circuit (2) selon l'une des revendications 1 ou 2,
**caractérisé en ce que**
au moins un commutateur commandé (8.1, 8.2) est réalisé sous la forme d'un transistor bipolaire (T1, T2) de type de construction NPN ou PNP, qui comprend notamment à chaque fois une base (B1, B2) comme entrée de commande et à chaque fois un émetteur (E1, E2) et à chaque fois un collecteur (K1, K2).

4. Arrangement de circuit (2) selon l'une des revendications 1 à 3,
**caractérisé en ce que**
le dispositif de surveillance (4) comprend un dispositif de limitation de la tension (7) pour la limitation et/ou la stabilisation de la tension.

5. Arrangement de circuit (2) selon l'une des revendications 1 à 4,
**caractérisé en ce que**
le dispositif de surveillance (4) comprend un réseau de résistances (R1, R2) et/ou un réseau de condensateurs (C1, C2) afin d'adapter les différences de potentiel électrique globalement et/ou localement au sein du dispositif de surveillance (4).

6. Arrangement de circuit (2) selon l'une des revendications 1 à 5,
**caractérisé en ce que**
la source de tension ou de courant (5) est réglée de manière commutable, notamment en fonction d'un signal de sortie d'un dispositif de protection contre le redémarrage (6).

7. Arrangement de circuit (2) selon l'une des revendications 1 à 6,
**caractérisé en ce que**
le circuit à semi-conducteur inflammable (1) comprend essentiellement au moins une grille de thyristor et/ou un TRIAC (D3).

8. Arrangement de circuit selon l'une des revendications 4 à 7,
**caractérisé en ce que**
le dispositif de limitation de la tension (7) comprend essentiellement deux diodes Z (Z1, Z2) montées en série dans des directions opposées, au moyen desquelles la tension électrique surveillée peut être limitée à une tension de petit signal.
